# EUROPEAN PATENT APPLICATION

(11) **EP 2 161 758 A1**
(43) Date of publication of application: **10.03.2010**
(21) Application number: 08163782.9
(22) Date of filing: 05.09.2008
(51) Int. Cl.: H01L 31/0352, H01L 31/18, H01L 31/0236, H01L 31/075

(54) **Solar cell and method for the production thereof**

(71) Applicant: Flexucell ApS, 9750 Østervraa (DK); Danfoss Ventures A/S, 6430 Nordborg (DK)
(72) Inventor: Larsen, Jens William, 9330, Dronninglund (DK); Kiil, Hans-Erik, 6200, Aabenraa (DK)
(74) Representative: Gregersen, Niels Henrik

(57) **Abstract**

A transducer (9), in particular solar cell, in the form of a photo electric transducer comprising in order: a substrate (1, 5), a rear side electrode (2, A), a photo electric active (photovoltaic) layer (3), a front side electrode (4, B), and a possible protective layer (6), where the substrate (1, 5) is constituted by an elastomer foil such as a silicone web or foil, that front side electrode (4, B) and rear side electrode (2, A) are constituted by electric conductive layers, which comprise electric conductive materials, or which is provided with an electric conductive coatings - by way of example of zinc oxide or another metallic compound, that the photo electric active (photovoltaic) layer (3) is constituted by a photo electric active coating by way of example a silicon compound, by way of example comprising amorphous or crystalline silicon. The front side of the substrate may be provided with a surface pattern of raised and depressed surface portions onto which the photo electric active layer is deposited. The surface pattern may comprise waves forming troughs and crests extending essentially in one common direction, thereby providing compliance in one direction. The elasticity together with the flexibility is very important features in order to make it possible to durably mount the solar cell on complex surfaces comprising inwards bending (concave) as well as outwards bending (convex) surface parts.

## Description

### Field of the Invention

The present invention relates to a transducer, in particular a solar cell, and of the type indicated in the preamble to claim 1.

The invention furthermore relates to a method for the production of a transducer, in particular a solar cell.

### Background of the Invention

The expression transducer shall in connection with the present invention be understood as a generic expression for a device being able to transform one energy form to another energy form, by way of example solar light to electricity.

Known solar cells usually have a relative small area on a relative stiff substrate, which thus may be an additional reason for the limitation of the practical area of use of solar cells.

WO 2008/010205 A2 discloses a thin-film photovoltaic conversion device, formed on a substrate, preferably made of a flexible plastic, having first and second conductive layers as electrodes, n-type and p-type layers, graded (varizone) band gap layer including pure silicon and silicon in chemical compositions selected from a group, consisting of SiₓGe_{1-x,} SiₓC_{y,} SiₓN_{y} and SiₓO_{y}N₂, all these chemical compositions being simultaneously comprised in graded band gap layer and smoothly changing from one to the other. The photovoltaic device additionally comprises reflective layer, an anti-reflective layer and a protective laminating layer.

### Object of the Invention

On this background the invention has for its purpose to provide a transducer, in particular a solar cell and a method for the production of such solar cells, which is provided in an elastic or a compliant manner, such that the field of application of the solar cells in practice may be considerably increased, and such that it is possible to attach the solar cells to various surfaces and possibly varying shapes.

### Description of the Invention

The transducer according to the invention is **characterized in that** said substrate is constituted by a polymer elastomer web or foil, that said front side electrode and rear side electrode are constituted by electric conductive layers, which comprise electric conductive materials, or which is provided with an electric conductive coatings - by way of example of zinc oxide or another metallic compound, that said photo electric active (photovoltaic) layer is constituted by a photo electric active coating by way of example a silicon compound, by way of example comprising amorphous or crystalline silicon, and that said possible protecting layer is constituted by a polymer elastomer web or foil.

Hereby is in a simple manner achieved an improved transducer in the form of a flexible and elastic solar cell, which in addition provides the flexible solar cell with very important elastic or compliant properties and increase the general area of use of the solar cell significantly. Furthermore, the elastic or compliant properties of the solar cell makes it possible to attach the solar cell to surfaces of various shapes, e.g. curved surfaces, even double curved surfaces. It is also possible to attach the solar cell to a surface having a shape which varies over time, e.g. due to environmental factors, such as changes in temperature, changes in moisture level, vibrations, shock, etc. Since the compliant properties of the solar cell allows it to follow such changes in shape of the surface having the solar cell attached thereto, it is prevented that such changes causes damage to the solar cell, e.g. in the form of cracks, fractures or tension, and the lifetime of the solar cell may thereby be prolonged.

Preferably, the transducer according to the invention is provided such that the substrate is constituted by a silicone web or foil. Thereby is obtained a transducer having a decreased weight as compared to transducers having a substrate made from a glass material or a metal, such as steel. Furthermore, the lifetime of the transducer is increased, because silicone is long-time stable with respect to solar light, and since the compliancy of the silicone web or foil is adapted to prevent transfer of mechanical tensions to the active layer in case of temperature variations or other mechanical effects. Finally, the manufacturing costs can be minimised because all process steps can be performed in an inline roll-to-roll process, and because the electrical connections between a plurality of cells in a solar panel can be deposited directly onto the substrate.

Appropriately, the transducer according to the invention is furthermore provided such that said possible protecting layer is constituted by transparent, elastic or compliant silicone web or foil.

The transducer according to the invention and comprising a foremost protecting layer, which is constituted by a transparent, flexible silicone web or foil, whereby the transducer in the form of a flexible, elastic solar cell be appropriate for mounting onto a transparent surface such as a window pane.

In order to further improve the elasticity as well as the efficiency the transducer according to the invention may advantageously be provided such that the front side of said substrate is provided with a surface pattern of raised and depressed surface portions onto which said photo electric active (photovoltaic) layer being deposited. It is an advantage that the raised and depressed surface portions are formed directly as a surface pattern on the substrate, rather than being formed by pre-straining or compressing the substrate or the transducer, because it is easier to control the direction of compliance, and because it is possible to design and control the pattern, including the size and shape of the raised and depressed surface pattern, in a very accurate manner. Thereby the properties of the transducer can be controlled and designed as desired.

The photo electric active (photovoltaic) layer may be in the form of a silicon compound, by way of example comprising amorphous or crystalline silicon.

More specific the transducer according to the invention may be provided such that said surface pattern comprises waves forming troughs and crests extending essentially in one common direction, each wave defining a height being a shortest distance between a crest and neighbouring troughs. According to this embodiment, the surface pattern provides compliance of the substrate along one direction, while the substrate is substantially stiff along a direction being substantially perpendicular to the compliant direction. Thus, the waves define an anisotropic characteristic facilitating movement in a direction which is perpendicular to the common direction. According to this embodiment, the crests and troughs resemble standing waves with essentially parallel wave fronts. However, the waves are not necessarily sinusoidal, but could have any suitable shape as long as crests and troughs are defined. According to this embodiment a crest (or a trough) will define substantially linear contour-lines, i.e. lines along a portion of the corrugation with equal height relative to the substrate in general. This at least substantially linear line will be at least substantially parallel to similar contour lines formed by other crest and troughs, and the directions of the at least substantially linear lines define the common direction. The common direction defined in this manner has the consequence that anisotropy occurs, and that movement of the transducer in a direction perpendicular to the common direction is facilitated, i.e. the transducer, or at least a photo electric active layer arranged on the corrugated surface, is compliant in a direction perpendicular to the common direction. As a consequence, the transducer can be attached to a curved surface without introducing cracks or creases in the transducer, because the transducer is capable of stretching and/or compressing along the compliant direction to follow the curves of the surface.

The photo electric active (photovoltaic) layer may be provided with a photo electric active coating in the form of a silicon compound, by way of example comprising amorphous or crystalline silicon.

As an alternative, the surface pattern may comprise waves forming troughs and crest extending essentially in at least two directions along the surface of the substrate. According to this embodiment, the substrate is compliant, and thereby stretchable, along at least two directions. As a consequence, it is possible to attach the transducer to a double curved surface without introducing cracks or creases in the transducer, since the transducer is capable of stretching along the two compliant directions. Thereby it is possible to attach the transducer to a large variety of different kinds of surfaces, such as cars or other vehicles, clothing, sports equipment, facades of buildings, etc. It is even possible to attach the transducer to a surface which changes shape over time.

The surface pattern may define a plurality of funnels, each funnel defining interior wall parts arranged relative to each other in such a manner that light incident on an interior wall part of a funnel is reflected onto another interior wall part of said funnel. According to this embodiment the surface pattern is designed in such a manner that it provides so-called "light-trapping". Thereby it can be ensured that light with various angles of incidence will reach the photo electric active (photovoltaic) layer. Furthermore, it is ensured that the part of the incident light which is reflected from an interior wall part reaches another interior wall part, i.e. the reflected light also reaches the photo electric active (photovoltaic) layer, possibly multiple times. Thereby the efficiency of the transducer is significantly increased.

The interior wall parts may advantageously be arranged in such a manner that they define an angle there between, the angle being smaller than 60°, such as smaller than 50°, such as smaller than 40°.

The funnels may advantageously be provided as microstructures, as nanostructures or as a combination of microstructures and nanostructures.

In general the transducer according to the invention is provided such that said photo electric active layer has a shape which is formed by the said surface pattern of the substrate. To enable elongation of the transducer in one or more directions, i.e. to provide compliance, the photo electric active layer preferably has a corrugated shape which renders the area of the photo electric active layer larger than the area occupied by the transducer in a relaxed state. The corrugated shape of the photo electric active layer thereby facilitates that the transducer can be stretched and/or compressed to follow the shape of a surface onto which the transducer is mounted, without having to stretch the photo electric active layer, but merely by evening out the corrugated shape of the photo electric active layer. According to this embodiment, the corrugated shape of the photo electric active layer is a replica of the surface pattern of the substrate.

The invention also relates to a method of the production of a transducer in the form of a solar cell on a substrate in the form of a preferably silicone web or foil, said method being characterized in carrying said silicone web or foil with said front side facing upwards supported on a top course of an endless conveyor or a similar transportation unit in successive order through the following treatment stations:
- in a first treatment station providing said surface pattern of the front side of said substrate with a plasma treating in an argon (Ar) atmosphere,
- in a second treatment station applying by RF-/DC-sputtering a rear side electrode an electric conductive layer in an argon (Ar) atmosphere,
- in a third treatment station applying by RF-/DC-sputtering one or more group of layers each consisting of a n-Si layer, a i-Si layer and a p-Si layer to said surface pattern of the front side of said substrate in an atmosphere of argon/hydrogen (Ar/H₂),
- in a fourth treatment station applying by RF-sputtering a front side electrode an electric conductive layer in an argon/oxygen (Ar/O₂) atmosphere,
- in a possible fifth treatment station applying an anti reflective (ARC) layer in an argon (Ar) atmosphere, and
- in a final treatment station, at the end of the endless belt conveyor, rolling up the finished solar cell.

Hereby is achieved a quite new and improved method for the production of not just flexible but also elastic solar cells with a possible length from 20 mm to 20000 mm or more and a width from 100 mm to 1500 mm, e.g. approximately 500 mm. In other words the new and inventive solar cells may be provided in rolls with a length as required by the customers. Of course the width and the length of the solar cell may be further adapted in accordance with specific customer orders.

The surface pattern of the front side of the silicone substrate causes a very significant increase of the area of the photovoltaic (electricity generating) layer of the solar cell, which means a similar significant increase of the efficiency of the solar cell according to the invention.

A very important further advantage is the economical side of the invention because also the production price and as a consequence also the sales price of the solar cells per area unit may be considerably minimized.

Preferably and more specific the method of the production of a transducer in accordance to the invention being characterized in carrying said silicone web or foil with said front side facing upwards supported on a top course of an endless conveyor or a similar transportation unit in successive order through the following treatment stations:
- in a first treatment station providing said surface pattern of the front side of said substrate with a plasma treating in an argon (Ar) atmosphere,
- in a second treatment station applying by DC-sputtering a rear side electrode in the form of a layer of silver (Ag) in an argon (Ar) atmosphere,
- in a third treatment station applying by RF-/DC-sputtering one or more group of layers each consisting of a n-Si layer, a i-Si layer and a p-Si layer to said surface pattern of the front side of said substrate in an atmosphere of argon/hydrogen (Ar/H₂),
- in a fourth treatment station applying by RF-sputtering a front side electrode either in the form of a layer of indium tin oxide (ITO) or in the form of a layer of zinc oxide (ZnO₂) in both cases in an argon/oxygen (Ar/O₂) atmosphere,
- in a possible fifth treatment station applying an anti reflective (ARC) layer in an argon (Ar) atmosphere, and
- in a final treatment station, at the end of the endless belt conveyor, rolling up the finished solar cell.

### Description of the Drawing

The invention is described in more detail with reference to the drawing, in which:
- Fig. 1: shows a plane sectional view of an embodiment of a solar cell according to the invention build up on a silicone web or foil,
- Fig. 2: shows a perspective view of the solar cell cf. Fig. 1 - as seen from above,
- Fig. 3: shows a plane view - partly in section - of another embodiment of a solar cell according to the invention build up on a silicone foil or web and with a protecting silicone foil on the front side,
- Fig. 4: shows a perspective view of the solar cell cf. Fig. 3 - as seen from above,
- Fig. 5: shows a plane view of a rolled up solar cell to the left hand side in top of Fig. 5, to the right hand side an enlarged view of the upper surface of the solar cell, while a lower sectional view shows the different layers of the solar cell,
- Fig. 6: shows a perspective view of an embodiment of the corrugation of the front surface of a substrate of a solar cell according to the invention,
- Fig. 7: shows a plane sectional view of the substrate cf. Fig. 6,
- Fig. 8: shows a plane sectional view illustrating "light trapping" of light beams between the waves of the corrugated surface of the substrate,
- Fig. 9: shows a perspective view of another embodiment of the corrugation of the front surface of a substrate of a solar cell according to the invention,
- Fig. 10: shows a perspective view illustrating a possible surface pattern of the front surface of a substrate for a solar cell according to the invention, and
- Fig. 11: shows a 3D view of a piece of an embodiment of solar cell according to the invention - illustrating the flexibility as well as the elasticity of the substrate in the form of a silicone web or foil.

### Detailed Description of the Invention

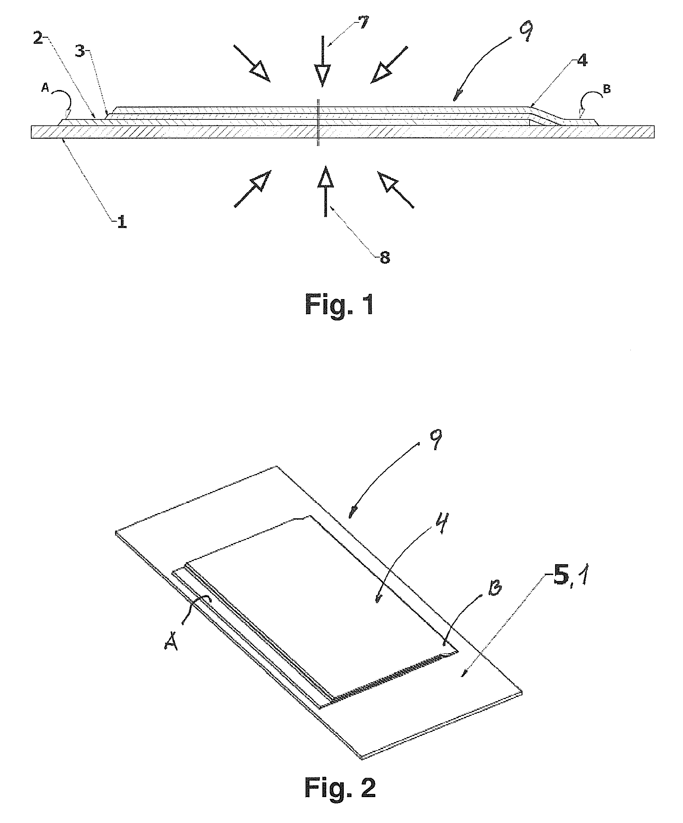

The solar cell 9 shown in Figs 1 and 2 is built up on a substrate or carrying material in the form of a silicone web or foil 1, 5. On top of the silicone web or foil 1, 5 is deposited a rear side electrode 2, A in the form of an electric conductive layer in the form of a layer of silver (Ag) deposited by DC-sputtering in an argon (Ar) atmosphere.

By RF-/DC-sputtering is then deposited one or more group of layers each consisting of a n-Si layer, a i-Si layer and a p-Si layer constituting the photo electric active layer 3 to the surface pattern of the front side of said substrate in an atmosphere of argon/hydrogen (Ar/H₂). The photovoltaic layer 3 may very often comprise up to three or more groups of n-Si, i-Si and p-Si layers.

Afterwards is by RF-sputtering deposited a front side electrode 4, B either in the form of a layer of indium tin oxide (ITO) or in the form of a layer of zinc oxide (ZnO₂) in both cases in an argon/oxygen (Ar/O₂) atmosphere. The in-coming light to the solar cells 9, is indicated by arrows 7, while arrows 8 at the opposite side of the solar cells 9, indicate a possible view out through the solar cell. In case the silicone substrate of the solar cell 9 is transparent, then also the whole solar cell 9 may be transparent.

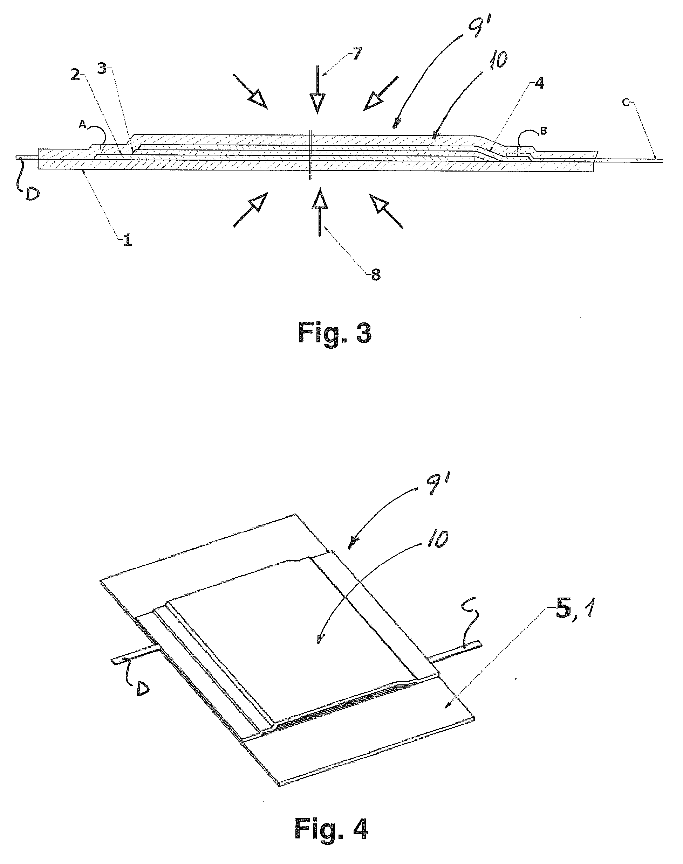

By the solar cell 9' shown in Figs. 3 and 4 most of the above described items are the same as the items of the solar cell 9 cf. Figs. 1 and 2 and the same reference numerals are used for identical items. However, the solar cell 9' shown in Figs, 3 and 4 comprises a further upper protective layer 10 in the form of a possible transparent silicone web or foil 10. Additionally, the solar cell 9' shown in Figs. 3 and 4 comprise an electric conductive terminal D connected to the rear side electrode 2, A and an electric conductive terminal C connected to the front side electrode 4, B.

Possibly the shown solar cells 9, 9'may furthermore comprise a not shown upper anti reflective layer (ARC) deposited to the upper surface of the solar cells 9, 9' in an argon (Ar) atmosphere.

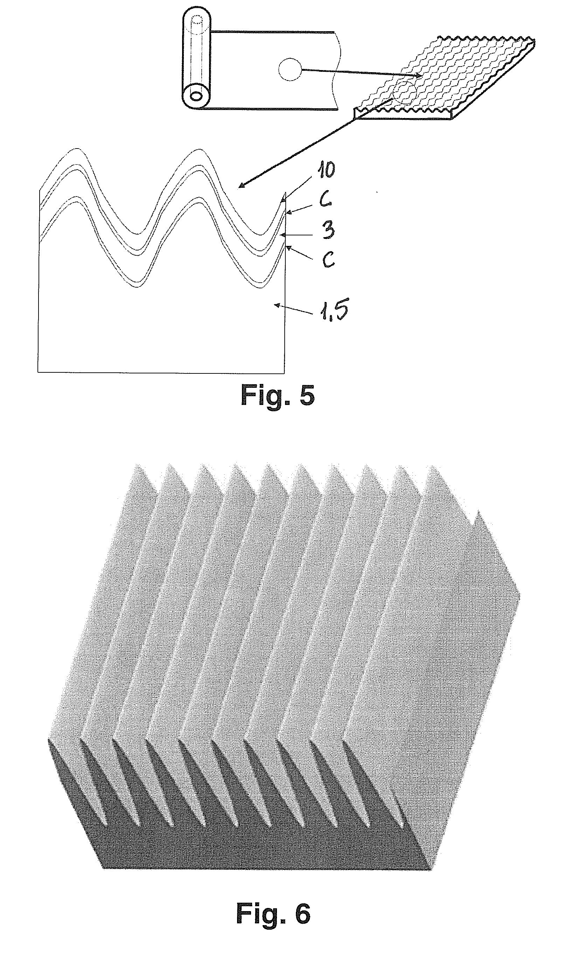

In three steps Fig. 5 shows a plane view of a rolled up solar cell according to the invention in the left hand side in the upper part of Fig. 5, to the right hand side is shown an enlarged perspective view of the corrugated upper surface of the substrate of the solar cell, while a lower further enlarged sectional view shows the different layers of the solar cell 9', namely an upper protective layer 10, a top electrode C, more electricity generating layers 3 and a coated silicone web or foil 1, 5 with 3D surface structure.

The upper surface of the substrate shown in Fig. 5 is corrugated in two directions along the surface. Accordingly, the solar cell is compliant in two directions, and it can thereby be stretched and/or compressed to fit surfaces of various shapes, such as double curved surfaces, as described above.

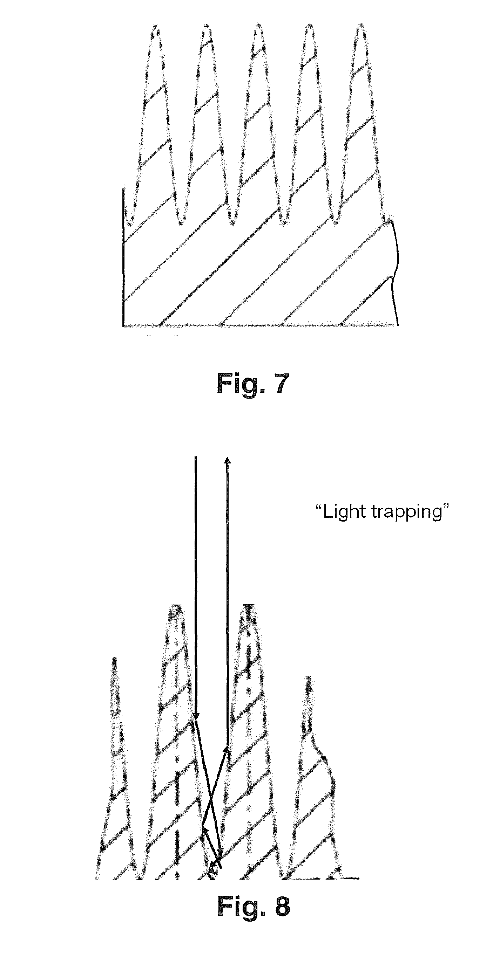

Figs. 6 and 7 show in a highly enlarged scale an embodiment of a solar cell substrate according to the invention in the form of a silicone web having 3D surface structure with uniformed straight waves. The solar cell substrate shown in Figs. 6 and 7 is provided with a surface pattern of raised and depressed surface portions in the form of waves forming troughs and crests extending essentially in one common direction. Thus, the solar cell substrate of Figs. 6 and 7 is compliant along a direction which is substantially perpendicular to the direction defined by the wave fronts, i.e. along a longitudinal direction of the substrate. The solar cell substrate is relatively stiff along the direction defined by the wave fronts. Thereby the solar cell can be stretched in the compliant direction, but not in the transversal direction.

Fig. 8 shows in a highly enlarged scale the situation called "light trapping" where an incoming light beam is reflected several times on the corrugated (waved) surface of a substrate of a solar cell and finally is possibly residual light thrown back from the solar cell. Such "light trapping" in the surface of a solar cell may cause an improvement of the efficiency of the solar cell.

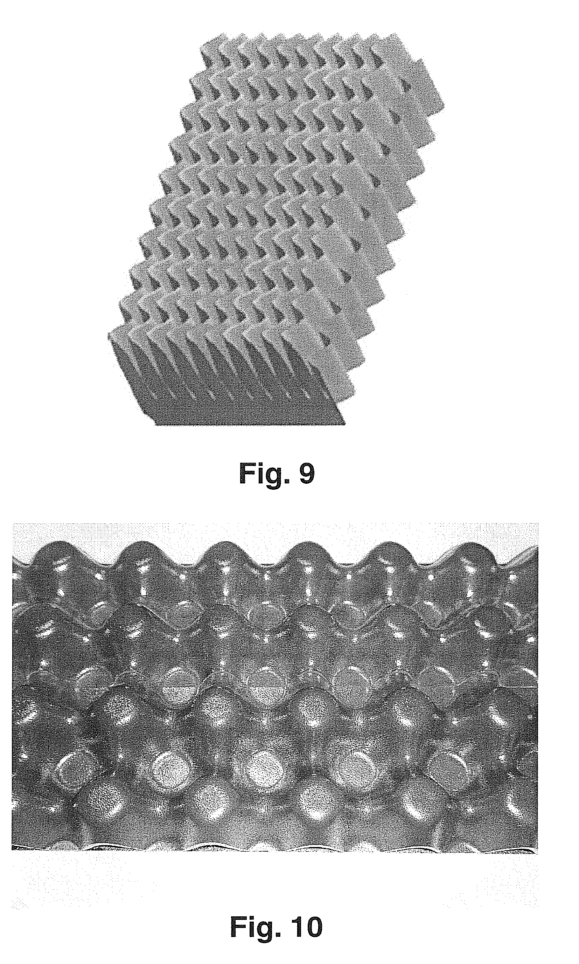

Fig. 9 shows in a highly enlarged scale a further embodiment of a solar cell substrate according to the invention in the form of a silicone web having a 3D surface structure with uniform waves with corrugations in more directions. Hereby the active surface of the solar cell may be significantly enlarged in order to improve the efficiency of the solar cell.

Furthermore, the solar cell substrate is compliant in a longitudinal direction as well as in a transversal direction. Thereby the solar cell is stretchable in both of these directions, and it is therefore possible to mount the solar cell on a large variety of different surfaces, such as double curved surfaces, e.g. concave or convex surfaces without risking to introduce cracks or creases in the substrate. Furthermore, since the photo electric active layer is coated onto the substrate in such a manner that it adopts the shape of the surface pattern, the photo electric active layer will simply move along with the surface of the substrate when it is stretched and/or compressed, and thereby no stress is introduced in the photo electric active layer.

Fig. 10 shows in a highly enlarged scale a still further embodiment of the surface of a solar cell substrate according to the invention in the form of a silicone web having a great number of blunt peaks and valleys (similar to an egg tray) in order to enlarge the surface area and thereby improve the efficiency of the solar cell. Furthermore this embodiment of the surface of the solar cell may cause an improved efficiency by the fact that incoming solar light from different directions may hit the inclined sides of the blunt peaks as well as the bottom surfaces of the valleys.

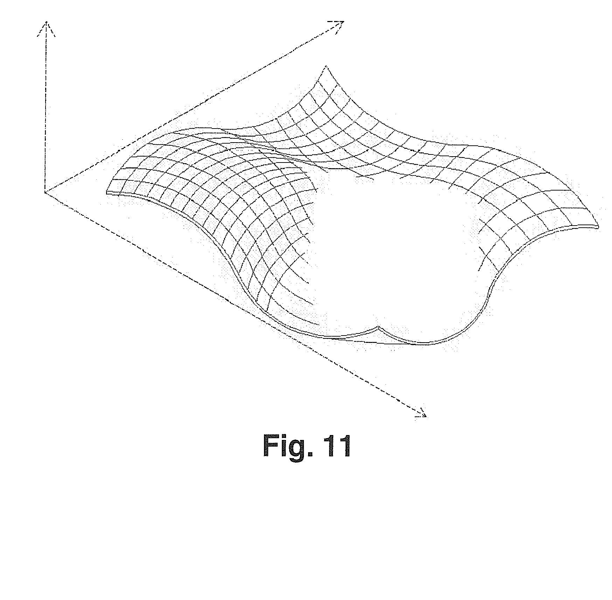

Fig. 11 shows a perspective, 3D view of a piece of an embodiment of a solar cell having a silicone substrate according to the invention - and illustrating the flexibility as well as the elasticity of the silicone substrate of the solar cell. The elasticity together with the flexibility is very important features in order to make it possible to durably mount the solar cell on complex surfaces comprising inwards bending (concave) as well as outwards bending (convex) surface parts.

As described above, the silicone substrate in itself possesses elastic properties allowing the substrate to be stretched to some extent. However, providing the surface of the silicone substrate with a surface pattern defining troughs and crests along one, two or more directions significantly enhances the elastic properties of the substrate. It should be noted that the elasticity of the solar cell renders the solar cell robust with respect to changes in the dimensions and/or shape of a surface having the solar cell attached thereto, since the elasticity of the solar cell allows it to change its shape to follow the changes in the mounting surface. This prolongs the expected lifetime of the solar cell and allows it to be attached to an even larger variety of different kinds of surfaces. Changes in the dimensions and/or shape of a surface having the solar cell attached thereto may, e.g., be caused by environmental influences, such as changes in temperature, changes in moisture level, vibrations, shocks, etc.

The rear side electrode and the top side electrode of the solar cell according to the invention of course have to be connected with an electric controlling circuit or other electric devices in a proper manner by way of example by means of contact portions or connectors as describes in WO 2008/052559 A2 page 50, line 21 - page 53, line 6 and in Figs. 23-36.

By the preferred method of the production of the solar cell according to the invention a silicone substrate is forwarded with said front side facing upwards supported on a top course of an endless conveyor or a similar transportation unit in successive order through the following treatment stations:
- in a first treatment station providing said surface pattern of the front side of said substrate with a plasma treating in an argon (Ar) atmosphere,
- in a second treatment station applying by DC-sputtering a rear side electrode in the form of a layer of silver (Ag) in an argon (Ar) atmosphere,
- in a third treatment station applying by RF-/DC-sputtering one or more group of layers each consisting of a n-Si layer, a i-Si layer and a p-Si layer to said surface pattern of the front side of said substrate in an atmosphere of argon/hydrogen (Ar/H₂),
- in a fourth treatment station applying by RF-sputtering a front side electrode either in the form of a layer of indium tin oxide (ITO) or in the form of a layer of zinc oxide (ZnO₂) in both cases in an argon/oxygen (Ar/O₂) atmosphere,
- in a possible fifth treatment station applying an anti reflective (ARC) layer in an argon (Ar) atmosphere, and
- in a final treatment station, at the end of the endless belt conveyor, rolling up the finished solar cell.

By said surface treatment in said first treatment station microscopic quartz crystals (SiO₂) or other quarts grains/structures are formed on the front side surface of the silicone substrate, e.g. by reconstructing or transforming residual compounds and/or depositing of supplementary compounds. Thereby the adherence of front side surface is significant improved for the subsequent application of further layers onto the front surface of the front side surface of the silicone substrate.

In said third treatment station is by RF-/DC-sputtering in an argon atmosphere typically built up a number of groups of at least three layers (p-Si layer, i-Si layer and n-Si layer) constituting the active electricity generating layer of solar cell, which is positioned on or between one or more layers of a silicone based web/foil or other geometric shape.

The three layers (or more) of the active layer of the solar cell consist respectively of a top electrode, which is transparent and electric conductive (TCO - Transparent Conductive Oxide), the photo active (photovoltaic) layer, and the electric conductive rear side electrode, which may be transparent or partly transparent or not transparent at all.

The active layer of the solar cell is coated on or joint with a substrate consisting of a silicone based polymer or elastomer - all polymers or elastomer comprising a silicon compound may be used.

The silicone substrate of the solar cell may be (but not necessarily) provided with fibres or other reinforcing elements, which increases the tensile strength and thereby the lifetime and makes the mounting easier.

The silicone substrate of the solar cell may be (but not necessarily) laminated or in another way joint together with another flexible or not flexible substrate in order to increase the tensile strength. Such increased tensile strength may be advantageous during the production, during the mounting, as well as during the use of the solar cell.

The primary purposes of the present invention can be listed as follows:
- to provide a solar cell on a silicone containing polymer (elastomer) substrate, web or foil;
- to form a photovoltaic cell module on a silicone based carrying material/substrate;
- to form a solar cell, which basically is flexible and elastic;
- to form a solar cell, which basically in its flexible and elastic form may be mounted on a rigid surface or carrier, which reduces or removes this flexibility/elasticity.

Furthermore the solar cell may be a combination of a photovoltaic solar cell, which is positioned in a foremost position and a thermo electric transducer positioned in a rearmost position. The thermic electric transducer takes up the thermal energy, which is not taken up by the photovoltaic solar cell, which is positioned at the front side.

The solar cell may consist of p-i-n type conductive layers of correct endowed amorphous hydrogen based silicon. Amorphous silicon absorbs about 40 times more efficiently than that of crystalline silicon. As TCO layer is in the first round used indium tin oxide (ITO). In order to increase the effect of the solar cell an anti reflective coating (ARC) may be applied. The temperature of the substrate shall be lowest possible, by way of example in the range of 100° - 400° C, preferably in the range of 150° - 250° C, as it otherwise would be impossible afterwards to deposit on a flexible polymer substrate.

It should be possible to deposit the individual layers by reactive RF-/DC-sputtering in an Ar/H₂ atmosphere. Hydrogen is added in order to fill out the present "dangling bonds" in the amorphous silicon layer, as these otherwise will function as electron traps and lower the efficiency.

### p-i-n-type layers:

| | | |
|---|---|---|
| p-Si layer: | Thickness abt. 8 nm | DC-sputtering rate = 3,5- 9 nm/min |
| i-Si layer: | Thickness abt. 400-500 nm | RF-sputtering rate = 7-8 nm/min |
| n-Si layer: | Thickness abt. 20 nm | DC-sputtering rate = 3-10 nm/min |

### Depositing of layers:

- Usually the metal layers (by way of example the rear side electrode) will be deposited by DC-sputtering.
- Usually metal oxides (by way of example the front side electrode, the TCO layer) will be deposited by RF-sputtering - however CVD and PECVD would also be possible.
- n-Si and p-Si layers can be deposited by DC-sputtering, but will more likely be deposited by RF-sputtering - however CVD and PECVD would also be possible.
- i-Si (the thick Si layer) can be deposited by RF-sputtering, PECVD or CVD.

During the depositing by sputtering the temperature of the substrate shall possibly be high (∼ 200°C). Therefore it is very important to be able to control the temperature of the substrate during the depositing/sputtering.

### Technical terms:

- PV:: Photovoltaic
- RF:: Radio Frequency
- DC:: Direct Current
- ARC:: Anti Reflective Coating
- TCO:: Transparent Conductive Oxide
- PVD:: Physical Vapour Deposition
- CVD:: Chemical Vapour Deposition
- PECVD:: Plasma Enhanced Chemical Vapour Deposition

### Drawing reference numbers:

- 1:: Substrate (silicone foil or web, carrying material)
- 2:: Rear side electrode (connector)
- 3:: Photo electric active (photovoltaic) layer (electricity generating layer)
- 4:: Front side electrode (connector)
- 5:: Substrate (silicone foil or web)
- 7:: Solar light (incoming solar light)
- 8:: Vision through the solar cell (front side and rear side electrodes are transparent)
- 9:: Transducer (solar cell)
- 10:: Upper protective layer (possibly transparent)
- A:: Rear side electrode (terminal/connector)
- B:: Front side electrode (terminal/connector)
- C:: Front side electrode (terminal/connector)
- D:: Rear side electrode (terminal/connector)

## Claims

1. A transducer, in particular solar cell, in the form of a photo electric transducer comprising in order:
- a substrate (1, 5),
- a rear side electrode (2, A),
- a photo electric active (photovoltaic) layer (3),
- a front side electrode (4, B), and
- a possible protective layer (10),
***characterized in,* that** said substrate (1, 5) is constituted by a polymer elastomer web or foil, that said front side electrode (4, B) and rear side electrode (2, A) are constituted by electric conductive layers, which comprise electric conductive materials, or which is provided with an electric conductive coatings - by way of example of zinc oxide or another metallic compound, that said photo electric active (photovoltaic) layer (3) is constituted by a photo electric active coating by way of example a silicon compound, by way of example comprising amorphous or crystalline silicon, and that said possible protecting layer (10) is constituted by a polymer elastomer web or foil.

2. Transducer according to claim 1, ***characterized in* that** said substrate (1, 5) is constituted by a silicone web or foil.

3. Transducer according to claim 1 or 2, ***characterized in* that** said possible protecting layer (10) is constituted by transparent, elastic silicone web or foil.

4. Transducer according to any of the preceding claims, ***characterized in*** comprising a foremost protecting layer, which is constituted by a transparent, elastic silicone web or foil.

5. Transducer according to any of the preceding claims, ***characterized in* that** the front side of said substrate is provided with a surface pattern of raised and depressed surface portions onto which said photo electric active (photovoltaic) layer being deposited.

6. Transducer according to claim 5, ***characterized in* that** said surface pattern comprises waves forming troughs and crests extending essentially in one common direction, each wave defining a height being a shortest distance between a crest and neighbouring troughs.

7. Transducer according to claim 5, ***characterized in* that** said surface pattern comprises waves forming troughs and crest extending essentially in at least two directions along the surface of the substrate.

8. Transducer according to any of claims 5-7, ***characterized in* that** said surface pattern defines a plurality of funnels, each funnel defining interior wall parts arranged relative to each other in such a manner that light incident on an interior wall part of a funnel is reflected onto another interior wall part of said funnel.

9. Transducer according to any of claims 5-8, ***characterized in* that** said photo electric active layer has a corrugated shape which is formed by the said surface pattern of the substrate.

10. Transducer according to any of the preceding claims, ***characterized in* that** said photo electric active (photovoltaic) layer is provided with a photo electric active coating in the form of a silicon compound, by way of example comprising amorphous or crystalline silicon.

11. A method of the production of a transducer in the form of a solar cell on a substrate in the form of a preferably silicone web or foil, and according to any of the preceding claims, ***characterized in*** carrying said silicone web or foil with said front side facing upwards supported on a top course of an endless conveyor or a similar transportation unit in successive order through the following treatment stations:
- in a first treatment station providing said surface pattern of the front side of said substrate with a plasma treating in an argon (Ar) atmosphere,
- in a second treatment station applying by RF-/DC-sputtering a rear side electrode an electric conductive layer in an argon (Ar) atmosphere,
- in a third treatment station applying by RF-/DC-sputtering one or more group of layers each consisting of a n-Si layer, a i-Si layer and a p-Si layer to said surface pattern of the front side of said substrate in an atmosphere of argon/hydrogen (Ar/H₂),
- in a fourth treatment station applying by RF-sputtering a front side electrode an electric conductive layer in an argon/oxygen (Ar/O₂) atmosphere,
- in a possible fifth treatment station applying an anti reflective (ARC) layer in an argon (Ar) atmosphere, and
- in a final treatment station, at the end of the endless belt conveyor, rolling up the finished solar cell.

12. A method according to claim 11, ***characterized in*** carrying said silicone web or foil with said front side facing upwards supported on a top course of an endless conveyor or a similar transportation unit in successive order through the following treatment stations:
- in a first treatment station providing said surface pattern of the front side of said substrate with a plasma treating in an argon (Ar) atmosphere,
- in a second treatment station applying by DC-sputtering a rear side electrode in the form of a layer of silver (Ag) in an argon (Ar) atmosphere,
- in a third treatment station applying by RF-/DC-sputtering one or more group of layers each consisting of a n-Si layer, a i-Si layer and a p-Si layer to said surface pattern of the front side of said substrate in an atmosphere of argon/hydrogen (Ar/H₂),
- in a fourth treatment station applying by RF-sputtering a front side electrode either in the form of a layer of indium tin oxide (ITO) or in the form of a layer of zinc oxide (ZnO₂) in both cases in an argon/oxygen (Ar/O₂) atmosphere,
- in a possible fifth treatment station applying an anti reflective (ARC) layer in an argon (Ar) atmosphere, and
- in a final treatment station, at the end of the endless belt conveyor, rolling up the finished solar cell.
